(19) Europäisches Patentamt
European Patent Office
Office européen des brevets

(11) **EP 4 254 661 A1**

(12) **EUROPEAN PATENT APPLICATION**
published in accordance with Art. 153(4) EPC

(43) Date of publication:
**04.10.2023 Bulletin 2023/40**

(21) Application number: **21908786.3**

(22) Date of filing: **19.10.2021**

(51) International Patent Classification (IPC):
*H01Q 1/38* (2006.01)          *H01Q 1/36* (2006.01)
*H01Q 13/08* (2006.01)          *H01Q 21/00* (2006.01)

(52) Cooperative Patent Classification (CPC):
**H01Q 1/36; H01Q 1/38; H01Q 1/50; H01Q 13/08;
H01Q 21/00**

(86) International application number:
**PCT/CN2021/124761**

(87) International publication number:
**WO 2022/134785 (30.06.2022 Gazette 2022/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.12.2020 CN 202011529058**

(71) Applicant: **Huawei Technologies Co., Ltd.
Shenzhen, Guangdong 518129 (CN)**

(72) Inventors:
• **SHAO, Jinjin
  Shenzhen, Guangdong 518129 (CN)**
• **SHI, Cao
  Shenzhen, Guangdong 518129 (CN)**
• **HE, Junfei
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **ANTENNA AND COMMUNICATION DEVICE**

(57)     This application provides an antenna and a communication device, and relates to the field of communication technologies, to solve a technical problem of a limited coverage of the antenna. The antenna provided in this application includes a dielectric substrate, a folded dipole, and N symmetrical dipoles. A combined line is disposed on the dielectric substrate, and the combined line has a first end and a second end. The folded dipole is located at the first end of the combined line and is connected to the combined line. The N symmetrical dipoles are disposed on the dielectric substrate, and the N symmetrical dipoles are connected to the combined line. The N symmetrical dipoles are sequentially arranged from the first end to the second end of the combined line. In an antenna provided in this application, bandwidth control of different frequency bands is implemented together by a folded dipole and a symmetrical dipole, increasing an operating bandwidth of the antenna. In addition, coherent superposition can be implemented, by arranging the folded dipole and the symmetrical dipole according to a specific size requirement, on an electromagnetic wave generated by the folded dipole and the symmetrical dipole, achieving a multi-beam characteristic and further achieving omnidirectional coverage of the antenna.

FIG. 1

## Description

This application claims priority to Chinese Patent Application No. 202011529058.7, filed with the China National Intellectual Property Administration on December 22, 2020 and entitled "ANTENNA AND COMMUNICATION DEVICE", which is incorporated herein by reference in its entirety.

## TECHNICAL FIELD

This application relates to the field of communication technologies, and in particular, to an antenna and a communication device.

## BACKGROUND

In a current wireless communication device, half-wave dipole antennas are mainly used. As a type of common narrowband antennas, the half-wave dipole antennas feature horizontal omnidirectional radiation and the like, and a maximum gain is about 2 dBi. In an actual application, a half-wave dipole antenna generally includes a pair of symmetrically provided conductors, and two ends of the two conductors close to each other are respectively connected to feeders, where a sum of lengths of the two conductors is approximately equal to half of an operating frequency of the two conductors. As the operating frequency of the antenna increases, a frequency of an electromagnetic wave emitted by the antenna increases accordingly. However, compared with a low-frequency electromagnetic wave, a high-frequency electromagnetic wave attenuates significantly under a same propagation distance, and has poor winding and wall penetration capabilities. However, because a frequency of the electromagnetic wave emitted by the half-wave dipole is highly related to a size and height of the half-wave dipole, the half-wave dipole antenna can generate only a beam with a single frequency band, and has low gains in a perpendicular direction, failing to achieve coverage of an entire area.

## SUMMARY

This application provides an antenna and a communication device that have wide coverage and are favorable to achieve a high gain and a multi-beam characteristic.

According to one aspect, this application provides an antenna. The antenna includes a dielectric substrate, a combined line, a folded dipole, and N symmetrical dipoles. The combined line is disposed on the dielectric substrate. The combined line has a first end and a second end. The folded dipole is disposed on the dielectric substrate. The folded dipole is located at the first end of the combined line and is connected to the combined line. The N symmetrical dipoles are disposed on the dielectric substrate. The N symmetrical dipoles are connected to the combined line, and N is an integer greater than or equal to 1. When N is greater than 1, the N symmetrical dipoles are sequentially arranged from the first end to the second end of the combined line.

In the antenna provided in this application, the folded dipole has a relatively strong radiation gain in a perpendicular direction, and the symmetrical dipole features horizontal omnidirectional radiation and the like. Coherent superposition can be implemented, by arranging the folded dipole and the symmetrical dipole according to a specific dimension constraint, on electromagnetic waves generated by the folded dipole and the symmetrical dipole, achieving a multi-beam characteristic. Therefore, superposition between the folded dipole and the symmetrical dipole is beneficial to achieve multi-directional coverage of the antenna. For example, applying a wireless router equipped with the foregoing antenna to a multi-storey structure help ensure coverage of a Wi-Fi signal on a same floor, and also improve coverage of a Wi-Fi signal on an upper floor and a lower floor.

During specific disposition, a distance L between the folded dipole and the symmetrical dipole at a tail part may be adaptively adjusted according to an actual condition. For example, the distance L may be greater than or equal to a quarter of an operating wavelength of the antenna, and may be less than or equal to the operating wavelength of the antenna. In this way, coherent superposition can be implemented on electromagnetic waves generated by the folded dipole and the symmetrical dipole at the tail part, achieving a multi-beam characteristic.

The symmetrical dipole at the tail part is a symmetrical dipole that is furthest from the folded dipole among the plurality of symmetrical dipoles. Alternatively, it may be understood that the symmetrical dipole at the tail part is a symmetrical dipole located at the second end of the combined line.

When a plurality of symmetrical dipoles are disposed, the plurality of symmetrical dipoles may be arranged according to a specific dimension constraint.

For example, lengths between the plurality of symmetrical dipoles may be set according to a dimension constraint in the following formula.

$$\frac{L_n}{L_{n+1}} = \tau < 1 \quad (1)$$

Alternatively, relative positions between the plurality of symmetrical dipoles may be arranged according to the dimension constraint in the following formula.

$$\frac{R_n}{R_{n+1}} = \tau < 1 \quad (2)$$

Alternatively, the relative positions between the plurality of symmetrical dipoles may be arranged according to the dimension constraint in the following formula.

$$\frac{d_n}{d_{n+1}} = \tau < 1 \quad (3)$$

N is a sequence number of the symmetrical dipole, and increases sequentially from a left end to a right end of the combined line. Ln is a length of an nth symmetrical dipole. Ln+1 is a length of an (n+1)th symmetrical dipole. Rn is a distance from the nth symmetrical dipole to a virtual vertex of the antenna. Rn+1 is a distance from the (n+1)th symmetrical dipole to the virtual vertex of the antenna. dn is a distance between the nth symmetrical dipole and the (n+1)th symmetrical dipole. dn+1 is a distance between the (n+1)th symmetrical dipole and an (n+2)th symmetrical dipole. τ is a combination factor of the antenna. In a specific application, a value of τ may be appropriately selected based on an actual requirement. For example, the value of τ may be 0.5, 0.6, 0.7, or the like. This is not limited in this application.

It may be understood that, during specific setting, the plurality of symmetrical dipoles may satisfy only any dimension constraint in the foregoing formulas (1) to (3), or may simultaneously satisfy any one or two or three dimension constraints in the foregoing formulas. Alternatively, the setting may be performed according to another dimension constraint. This is not limited in this application.

In some implementations, the dielectric substrate may be a structure such as a printed circuit board or a flexible circuit board. The combined line may be formed on the dielectric substrate by using a process such as photolithography. The combined line includes a first microstrip and a second microstrip, and a gap is maintained. Width sizes of the first microstrip and the second microstrip may be the same, so as to ensure operating stability of the symmetrical dipole and the folded dipole. In a specific implementation, the combined line may also be referred to as a parallel strip line. The first microstrip and the second microstrip may maintain a mutually parallel or an approximately parallel relationship.

In addition, the symmetrical dipole may include a first vibration arm and a second vibration arm, and the first vibration arm and the second vibration arm are symmetrically configured relative to the combined line. The first vibration arm may be disposed on a side of the first microstrip, and an end that is of the first vibration arm and that is close to the first microstrip is connected to the first microstrip. The second vibration arm may be disposed on a side of the second microstrip, and an end that is of the second vibration arm and that is close to the second microstrip is connected to the second microstrip.

During specific disposition, the symmetrical dipole at the tail part may be used as an excitation unit of the antenna. To satisfy a connection between the antenna and a related feed component, the antenna may be connected through one end of a coaxial cable, and the other end of the coaxial cable may be connected to the related feed component. The coaxial cable generally includes a cable core and an outer conductor located on the periphery of the cable core. Therefore, the symmetrical dipole at the tail part may be provided with a feed end. Specifically, the first vibration arm may have a first feed end, and the first feed end is located at an end that is of the first vibration arm and that faces the second vibration arm. The second vibration arm may have a second feed end, and the second feed end is located at an end that is of the second vibration arm and that faces the first vibration arm.

Considering that in the coaxial cable, a size of the outer conductor is greater than a size of the cable core, unbalanced feeding occurs when the coaxial cable is connected to the antenna. Therefore, during specific disposition, a balun structure may be further disposed in the antenna, to balance feeding.

During specific disposition, the balun structure may be disposed on a side that is of the symmetrical dipole at the tail part and that is away from the folded dipole, and is connected to the symmetrical dipole at the tail part. A specific structure type of the balun structure can be appropriately selected and adjusted based on different requirements. For example, the balun structure may be a bent U-shaped structure, and one end of the balun structure may be connected to the first vibration arm, the other end may be connected to the second vibration arm.

Alternatively, in another implementation, the problem of unbalanced feeding may be tackled using other structure setting.

For example, an end close to the first vibration arm and an end close to the second vibration arm may be connected to each other, and a slot exists between the first vibration arm and the second vibration arm. An end that is of the first vibration arm and that is close to the first microstrip may be connected to the first microstrip line, and an end of the second microstrip may extend into the slot. During connecting, the outer conductor of the coaxial cable may be connected to the first feed end on the first vibration arm or the second vibration arm, and an inner conductor of the coaxial cable may be connected to the second microstrip. Therefore, feeding is performed between the antenna and the coaxial cable by implementing a coplanar waveguide, so as to balance feeding between the antenna and the coaxial cable.

In addition, during specific disposition, relatively common folded dipoles in conventional technologies may be used for the folded dipoles, or flexible processing may be performed on the folded dipoles.

For example, the folded dipole may include a first connecting arm and a second connecting arm. The first connecting arm and the second connecting arm are coaxially disposed, and the first connecting arm and the second connecting arm are symmetrically configured relative to the combined line. An end of the first connecting arm is connected to the first microstrip, and an end of the second connecting arm is connected to the second microstrip.

In addition, an operating wavelength of the folded dipole may be increased. During specific disposition, the first connecting arm of the folded dipole further has a first extension section extending in a direction away from the second connecting arm. The second connecting arm has a second extension section extending in a direction away from the first connecting arm. The operating wavelength of the folded dipole may be increased by setting the first extension section and the second extension section. Specific lengths of the first extension section and the second extension section may be set based on an actual condition. This is not specifically limited in this application.

According to another aspect, an embodiment of this application further provides a communication device. The communication device includes a signal processing circuit and the foregoing antenna. The signal processing circuit may be electrically connected to the antenna through a coaxial cable. The communication device may be a wireless router, a mobile phone, a tablet computer, or the like. The signal processing circuit is electrically connected to the antenna to input or output a radio frequency signal. The electronic device has better antenna performance, and is capable of achieving a relatively wide frequency band and omnidirectional coverage.

**BRIEF DESCRIPTION OF DRAWINGS**

FIG. 1 is a schematic diagram of a planar structure of an antenna according to an embodiment of this application;
FIG. 2 is a schematic diagram of a planar structure of another antenna according to an embodiment of this application;
FIG. 3 is a schematic diagram of a planar structure of another antenna according to an embodiment of this application;
FIG. 4 is a schematic diagram of a planar structure of another antenna according to an embodiment of this application;
FIG. 5 is a cross-sectional view of a coaxial cable according to an embodiment of this application;
FIG. 6 is a schematic diagram of a planar structure of another antenna according to an embodiment of this application;
FIG. 7 is a schematic diagram of a planar structure of another antenna according to an embodiment of this application;
FIG. 8 is a signal simulation diagram of an antenna according to an embodiment of this application;
FIG. 9 is a simulation diagram of radiation intensity of an antenna according to an embodiment of this application;

FIG. 10 is an antenna radiation pattern corresponding to FIG. 9;
FIG. 11 is a radiation pattern of an antenna in another direction according to an embodiment of this application; and
FIG. 12 is a radiation pattern of an antenna in another direction according to an embodiment of this application.

**DESCRIPTION OF EMBODIMENTS**

To make the objectives, technical solutions, and advantages of this application clearer, the following further describes this application in detail with reference to the accompanying drawings.

To facilitate understanding of the antenna provided in embodiments of this application, the following first describes an application scenario of the antenna.

The antenna provided in embodiments of this application may be used in a communication device, and is configured to enable the communication device to receive or send a wireless signal, to implement a wireless communication function. The communication device may be a wireless router, a mobile phone, a tablet computer, a notebook computer, a vehicle-mounted device, a wearable device, or the like.

A router is used as an example. The router usually generates a Wi-Fi signal with specific coverage using an antenna. Devices such as a mobile phone and a tablet computer within the coverage may implement signal interconnection with the router. To achieve higher-rate signal transmission, the Wi-Fi signal gradually covers a frequency band from 2G to 5G or even a higher frequency band. In the current routers, half-wave dipole antennas are mainly used. As a type of common narrowband antennas, the half-wave dipole antennas feature horizontal omnidirectional radiation and the like, and a maximum gain is about 2 dBi. As an operating frequency of the antenna increases, the frequency of the electromagnetic wave emitted by the antenna increases accordingly. However, compared with a low-frequency electromagnetic wave, a high-frequency electromagnetic wave attenuates significantly under a same propagation distance, and has poor winding and wall penetration capabilities. However, because a frequency of the electromagnetic wave emitted by the half-wave dipole is highly related to a size and height of the half-wave dipole, the half-wave dipole antenna can generate only a beam with a single frequency band, and has low gains in a perpendicular direction, failing to achieve coverage of an entire area.

In addition, a common directional antenna usually presents a single-beam characteristic, and coverage of the directional antenna is reduced when a gain is improved. Correspondingly, in a process of increasing the coverage of the directional antenna, the gain of the directional antenna is significantly reduced. Therefore, for the directional antenna, more gains indicate smaller coverage, and therefore an effect of high gains and large coverage cannot be achieved simultaneously.

Therefore, an embodiment of this application provides an antenna that has a relatively large gain and is beneficial to achieve omnidirectional coverage.

To make the objectives, technical solutions, and advantages of this application clearer, the following further describes this application in detail with reference to the accompanying drawings and specific embodiments.

Terms used in the following embodiments are merely intended to describe specific embodiments, but are not intended to limit this application. As used in the specification and the appended claims of this application, the singular expressions "one", "one", "the above", "the" and "this" are intended to also include such expressions as "one or more", unless the context clearly indicates to the contrary. It should be further understood that in the following embodiments of this application, "at least one" and "one or more" refer to one, two, or more. The term "and/or" is used for describing an association relationship between associated objects, and indicates that three relationships may exist. For example, A and/or B may represent: Only A exists, both A and B exist, and only B exists, where A and B may be singular or plural. The character "/" generally indicates that the associated objects are in an "or" relationship.

Reference to "an embodiment", "some embodiments", or the like described in this specification indicates that one or more embodiments of this application include a specific characteristic, structure, or feature described with reference to the embodiment. Therefore, statements "in one embodiment", "in some embodiments", "in some other embodiments", "in other embodiments" and the like in the different places in this specification do not necessarily refer to the same embodiment, but rather means "one or more but not all embodiments", unless otherwise specifically emphasized. The terms "include", "comprise", "have", and variations thereof all mean "including, but not limited to", unless otherwise specifically emphasized.

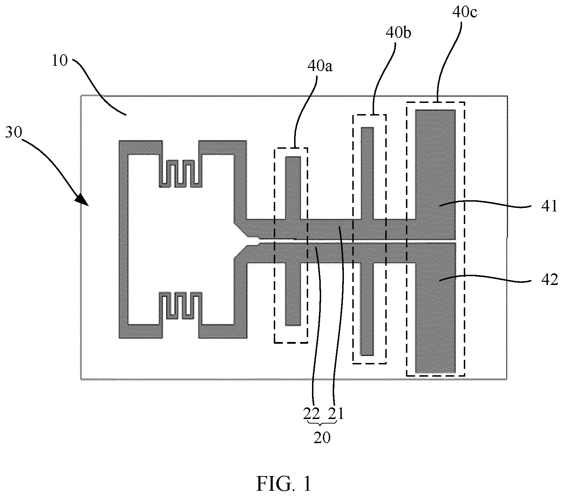

As shown in FIG. 1, in an embodiment provided in this application, an antenna includes a dielectric substrate 10, a folded dipole 30, and three symmetrical dipoles. The three symmetrical dipoles are respectively a symmetrical dipole 40a, a symmetrical dipole 40b, and a symmetrical dipole 40c. A combined line 20 is disposed on the dielectric substrate 10, and the folded dipole 30, the symmetrical dipole 40a, the symmetrical dipole 40b, and the symmetrical dipole 40c are all disposed on the dielectric substrate 10 and connected to the combined line 20. The folded dipole 30, the symmetrical dipole 40a, the symmetrical dipole 40b, and the symmetrical dipole 40c may be configured to convert current energy into electromagnetic energy and radiate the electromagnetic energy, and a distance L between the symmetrical dipole 40c and the folded dipole 30 may be provided according to a specific dimension constraint, so as to form a series-fed binary antenna array design. The symmetrical dipole 40a and the symmetrical dipole 40b are disposed between the folded dipole 30 and the symmetrical dipole 40c, and the symmetrical dipole 40a and the symmetrical dipole 40b are sequentially arranged from the folded dipole 30 to the symmetrical dipole 40c. A radiation capability of the symmetrical dipole 40c to a direction of the folded dipole 30 can be effectively improved by the symmetrical dipole 40a and the symmetrical dipole 40b, and bandwidth of the antenna can also be effectively increased.

In the embodiment provided in this application, the folded dipole 30 has a relatively strong radiation gain in a perpendicular direction, and the symmetrical dipole 40c features horizontal omnidirectional radiation and the like. Coherent superposition can be implemented, by arranging the folded dipole 30 and the symmetrical dipole 40c according to a specific dimension constraint, on electromagnetic waves generated by the folded dipole 30 and the symmetrical dipole 40c, achieving a multi-beam characteristic. Therefore, superposition between the folded dipole 30 and the symmetrical dipole 40c is beneficial to achieve multi-directional coverage of the antenna. For example, applying a wireless router equipped with the foregoing antenna to a multi-storey structure help ensure coverage of a Wi-Fi signal on a same floor, and also improve coverage of a Wi-Fi signal on an upper floor and a lower floor.

Generally speaking, in an actual application, the antenna may include the folded dipole 30 and N symmetrical dipoles, where N is an integer greater than or equal to 1. The folded dipole 30 may be disposed at the first end (the left part in the figure) of the combined line 20, and the N symmetrical dipoles may be sequentially arranged from a first end to a second end (that is, from left to right) of the combined line 20.

In a specific implementation, the dielectric substrate 10 may be a structure such as a printed circuit board or a flexible circuit board. The combined line 20 may be formed on the dielectric substrate 10 by using a process such as photolithography. The combined line 20 includes a first microstrip 21 and a second microstrip 22, and there is a gap between the first microstrip 21 and the second microstrip 22. Width sizes of the first microstrip 21 and the second microstrip 22 may be the same, to ensure operating stability of the symmetrical dipole 40 and the folded dipole 30. In specific implementation, the combined line 20 may also be referred to as a parallel strip line. The first microstrip 21 and the second microstrip 22 may be in a parallel or an approximately parallel relationship.

As shown in FIG. 1, when the symmetrical dipole 40c is specifically disposed, the symmetrical dipole 40c may include a first vibration arm 41 and a second vibration arm 42, and the first vibration arm 41 and the second vibration arm 42 are symmetrically configured relative to the combined line 20. The first vibration arm 41 and the second vibration arm 42 may be disposed coaxially, and an end of the first vibration arm 41 is connected to the first microstrip 21, and an end of the second vibration arm 42 is connected to the second microstrip 22. The symmetrical dipole may also be understood as a dipole, a half-wave dipole, or the like. Symmetrical disposition of the first vibration arm 41 and the second vibration arm 42 means symmetry in positions. In specific implementation, structural sizes of the first vibration arm 41 and the second vibration arm 42 may be the same or different.

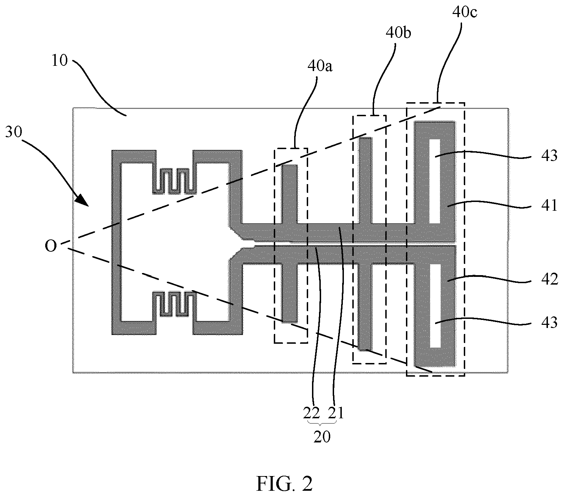

As shown in FIG. 2, in another disposition manner, a gap 43 may be further provided in a first vibration arm 41 and a second vibration arm 42, to perform capacitive loading on a symmetrical dipole 40c, thereby optimizing operating performance of the symmetrical dipole 40c.

A symmetrical dipole 40a and a symmetrical dipole 40b may be disposed in a same manner or similar manners according to a structure of the foregoing symmetrical dipole 40c, and details are not described herein again.

During specific disposition, a distance L between the symmetrical dipole 40c and a folded dipole 30 may range from a quarter of an operating wavelength of an antenna to an entire operating wavelength. In this way, coherent superposition can be implemented on electromagnetic waves generated by the folded dipole 30 and the symmetrical dipole 40c, achieving a multi-beam characteristic.

In addition, during specific disposition, the symmetrical dipole 40a, the symmetrical dipole 40b, and the symmetrical dipole 40c may be disposed according to a specific dimension constraint, so as to effectively improve a radiation capability of the symmetrical dipole 40c to a direction of the folded dipole 30, and bandwidth of the antenna can also be effectively increased.

For example, in the embodiment provided in this application, lengths between the symmetrical dipole 40a, the symmetrical dipole 40b, and the symmetrical dipole 40c may be arranged in a form of a logarithmic period. Specifically, the symmetrical dipole 40a, the symmetrical dipole 40b, and the symmetrical dipole 40c may be arranged by satisfying a dimension constraint in the following formula.

$$\frac{L_n}{L_{n+1}} = \tau < 1 \quad (1)$$

N is a sequence number of the symmetrical dipole, and increases sequentially from a left end to a right end of the combined line 20. That is, the symmetrical dipole 40a is a first symmetrical dipole, the symmetrical dipole 40b is a second symmetrical dipole, and the symmetrical dipole 40c is a third symmetrical dipole.

Ln is a length of an nth symmetrical dipole. Ln+1 is a length of an (n+1)th symmetrical dipole. For example, in the symmetrical dipole 40c, a length of the symmetrical dipole 40c is a sum of lengths of the first vibration arm 41 and the second vibration arm 42. Generally, the length of the symmetrical dipole 40c is approximately equal to half of the wavelength of electromagnetic waves transmitted or received by the symmetrical dipole 40c.

τ is a combination factor of the antenna. In a specific application, a value of τ may be appropriately selected based on an actual requirement. For example, the value of τ may be 0.5, 0.6, 0.7, or the like. This is not limited in this application.

In some other implementations, the symmetrical dipole 40a and the symmetrical dipole 40b may be disposed according to a specific dimension constraint, so as to effectively improve the radiation capability of the symmetrical dipole 40c to the direction of the folded dipole 30, and bandwidth of the antenna can also be effectively increased.

For example, in the embodiment provided in this application, relative positions between the symmetrical dipole 40a, the symmetrical dipole 40b, and the symmetrical dipole 40c may be arranged in the form of the logarithmic period. Specifically, the symmetrical dipole 40a, the symmetrical dipole 40b, and the symmetrical dipole 40c may be arranged by satisfying a dimension constraint in the following formula.

$$\frac{R_n}{R_{n+1}} = \tau < 1 \quad (2)$$

N is the sequence number of the symmetrical dipole, and increases sequentially from the left end to the right end of the combined line 20. That is, the symmetrical dipole 40a is the first symmetrical dipole, the symmetrical dipole 40b is the second symmetrical dipole, and the symmetrical dipole 40c is the third symmetrical dipole. Rn is a distance from the nth symmetrical dipole to a virtual vertex O of the antenna. Rn+1 is a distance from the (n+1)th symmetrical dipole to the virtual vertex O of the antenna. In an antenna structure shown in FIG. 2, the symmetrical dipole 40a, the symmetrical dipole 40b, and the symmetrical dipole 40c have lengths decreasing in order. Therefore, top ends of the symmetrical dipole 40a, the symmetrical dipole 40b, and the symmetrical dipole 40c located on an upper side of the combined line 20 are located on the same straight line. Correspondingly, top ends (lower ends in the figure) of the symmetrical dipole 40a, the symmetrical dipole 40b, and the symmetrical dipole 40c located on a lower side of the combined line 20 are also located on the same straight line. An intersection of the two straight lines forms the virtual vertex O.

τ is the combination factor of the antenna. In the specific application, the value of τ may be appropriately selected based on the actual requirement. For example, the value of τ may be 0.5, 0.6, 0.7, or the like. This is not limited in this application.

In some other implementations, the symmetrical dipole 40a and the symmetrical dipole 40b may be disposed according to another dimension constraint, so as to effectively improve the radiation capability of the symmetrical dipole 40c to the direction of the folded dipole 30, and bandwidth of the antenna can also be effectively increased.

For example, in the embodiment provided in this application, the relative positions between the symmetrical dipole 40a, the symmetrical dipole 40b, and the symmetrical dipole 40c may be arranged in the form of the logarithmic period. Specifically, the symmetrical dipole 40a, the symmetrical dipole 40b, and the symmetrical dipole 40c may be arranged by satisfying a dimension constraint in the following formula.

$$\frac{d_n}{d_{n+1}} = \tau < 1 \quad (3)$$

N is the sequence number of the symmetrical dipole, and increases sequentially from the left end to the right end of the combined line 20. That is, the symmetrical dipole 40a is the first symmetrical dipole, the symmetrical dipole 40b is the second symmetrical dipole, and the symmetrical dipole 40c is the third symmetrical dipole.

dn is a distance between the nth symmetrical dipole and the (n+1)th symmetrical dipole. dn+1 is a distance between the (n+1)th symmetrical dipole and an (n+2)th symmetrical dipole.

$\tau$ is the combination factor of the antenna. In the specific application, the value of $\tau$ may be appropriately selected based on the actual requirement. For example, the value of $\tau$ may be 0.5, 0.6, 0.7, or the like. This is not limited in this application.

It may be understood that, in a specific implementation, a plurality of symmetrical dipoles may satisfy only any dimension constraint in the foregoing formulas (1) to (3), or may simultaneously satisfy any one or two or three dimension constraints in the foregoing formulas. In addition, during the specific setting, a quantity of symmetrical dipoles may also be one, three, or more. Parameters such as a disposition position and a size of the symmetrical dipole may also be correspondingly disposed based on an actual condition. This is not specifically limited in this application. Alternatively, in some other implementations, the symmetrical dipole may not be disposed.

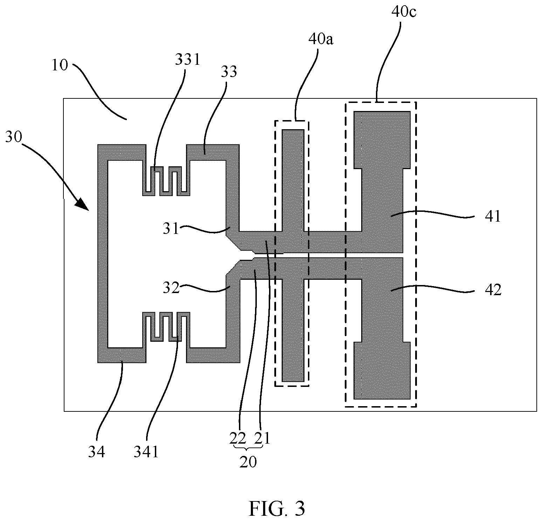

For example, as shown in FIG. 3, in an embodiment provided in this application, a symmetrical dipole 40a is disposed between a folded dipole 30 and a symmetrical dipole 40c. Alternatively, it may be understood that the foregoing symmetrical dipole 40b is omitted. In this way, a structure of an antenna is effectively simplified, thereby improving convenience of manufacturing, and effectively reducing manufacturing costs and complexity. In addition, in a specific implementation, the symmetrical dipole 40c may further perform overall widening processing or local widening processing. As shown in FIG. 3, in an embodiment provided in this application, widening processing is performed on an end of a first vibration arm 41, and correspondingly, the widening processing is also performed on an end of a second vibration arm 42. In this manner, radiation performance of a symmetrical dipole 40c may be improved, so as to improve a radiation capability of the symmetrical dipole 40c to a direction of a folded dipole 30, and bandwidth of the antenna can also be effectively increased.

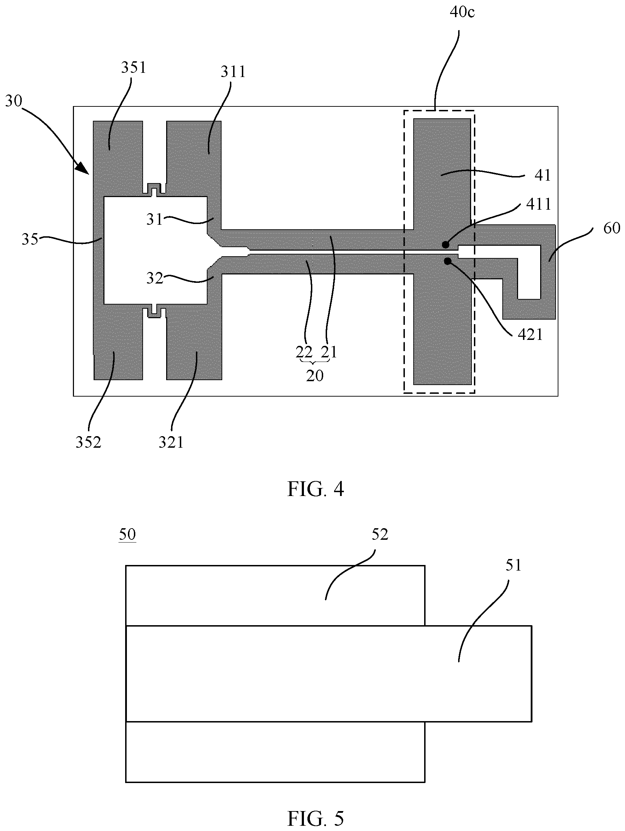

Alternatively, as shown in FIG. 4, in another embodiment provided in this application, an antenna includes a folded dipole 30 and a symmetrical dipole 40c. That is, the foregoing symmetrical dipole 40a and symmetrical dipole 40b are omitted. When the symmetrical dipole 40a and the symmetrical dipole 40b are omitted, a structure of the antenna can be effectively simplified, thereby improving convenience of manufacturing and effectively reducing manufacturing costs and complexity.

In a specific implementation, a relatively common folded dipole 30 in a conventional technology may be used for the folded dipole 30, or flexible processing may be performed on the folded dipole 30.

For example, in the embodiment provided in this application, the folded dipole 30 includes a first connecting arm 31, a second connecting arm 32, a third connecting arm 33, and a fourth connecting arm 34. The first connecting arm 31 and the second connecting arm 32 are coaxially disposed, and the first connecting arm 31 and the second connecting arm 32 are symmetrically configured relative to a combined line 20. An end of the first connecting arm 31 is connected to a first microstrip 21, and an end of the second connecting arm 32 is connected to a second microstrip 22. Generally, an operating wavelength of the folded dipole 30 (a wavelength at which the folded dipole 30 transmits or receives electromagnetic waves) is approximately twice a total length of the first connecting arm 31 and the second connecting arm 32. The third connecting arm 33 is provided with a bending structure 331, and the fourth connecting arm 34 is provided with a bending structure 341. The bending structure 331 and the bending structure 341 facilitate miniaturization of the folded dipole 30, thereby reducing a volume of the folded dipole 30. In addition, the bending structure 331 and the bending structure 341 are also beneficial to reduce a resonance frequency of the folded dipole 30, so that the folded dipole 30 is in a normal operating frequency band.

In addition, as shown in FIG. 4, in another embodiment provided in this application, a first connecting arm 31 of a folded dipole 30 further has a first extension section 311 extending in a direction away from a second connecting arm 32. The second connecting arm 32 has a second extension section 321 extending in a direction away from the first connecting arm 31. Two ends of a fifth connecting arm 35 are respectively provided with a third extension section 351 and a fourth extension section 352. An operating wavelength of the folded dipole 30 may be increased by setting the first extension section 311, the second extension section 321, the third extension section 351, and the fourth extension section 352. Specific lengths of the first extension section 311, the second extension section 321, the third extension section 351, and the fourth extension section 352 may be set based on an actual condition. This is not specifically limited in this application.

It may be understood that, in a specific application, a structure of the folded dipole 30 may be appropriately selected and adjusted based on different requirements. This is not limited in this application.

In addition, refer to FIG. 5. In an actual application, an antenna needs to be connected to a signal processing circuit through a coaxial cable 50. The coaxial cable 50 generally includes a cable core 51 and a cylindrical outer conductor 52 wrapped around the periphery of the cable core 51. As an excitation unit of the antenna, a symmetrical dipole 40 needs to be connected to the coaxial cable 50.

Refer to FIG. 4 and FIG. 5. Specifically, a first feed end 411 is disposed on a first vibration arm 41 of a symmetrical dipole 40, and a second feed end 421 is disposed on a second vibration arm 42. The first feed end 411 is located at an end that is of the first vibration arm 41 and that is close to the second vibration arm 42. Correspondingly, the second feed end 421 is located at an end that is of the second vibration arm 42 and that is close to the first vibration arm 41.

Considering that a size of the outer conductor 52 of the coaxial cable 50 is greater than a size of the cable core 51, to achieve a good connection between the coaxial cable 50 and the antenna, the antenna may further tackle a problem of unbalanced feeding using other structure setting.

For example, as shown in FIG. 4, in an embodiment provided in this application, the antenna further includes a balun structure 60. The balun structure 60 is provided on a side that is of the symmetrical dipole 40c and that is away from the folded dipole 30, and is connected to the symmetrical dipole 40c.

Specifically, in an embodiment provided in this application, the balun structure 60 is a bent U-shaped structure. One end of the U-shaped structure is connected to the first vibration arm 41, and the other end of the U-shaped structure is connected to the second vibration arm 42.

During specific disposition, when the first feed end 411 is connected to an inner conductor 51 of the coaxial cable 50, and the second feed end 421 is connected to the outer conductor 52 of the coaxial cable 50, to balance feeding between the symmetrical dipole 40 and the coaxial cable 50, the U-shaped structure may be bent in a direction in which the second vibration arm 42 extends.

When the first feed end 411 is connected to the outer conductor 52 of the coaxial cable 50, and the second feed end 421 is connected to the inner conductor 51 of the coaxial cable 50, to balance feeding between the symmetrical dipole 40 and the coaxial cable 50, the U-shaped structure may be bent in a direction in which the first vibration arm 41 extends.

It may be understood that in a specific implementation, a specific size and a structural form of the balun structure 60 may be adaptively adjusted based on an actual requirement. This is not limited in this application.

In addition, to balance feeding between the antenna and the coaxial cable, the antenna may further be provided with other structures.

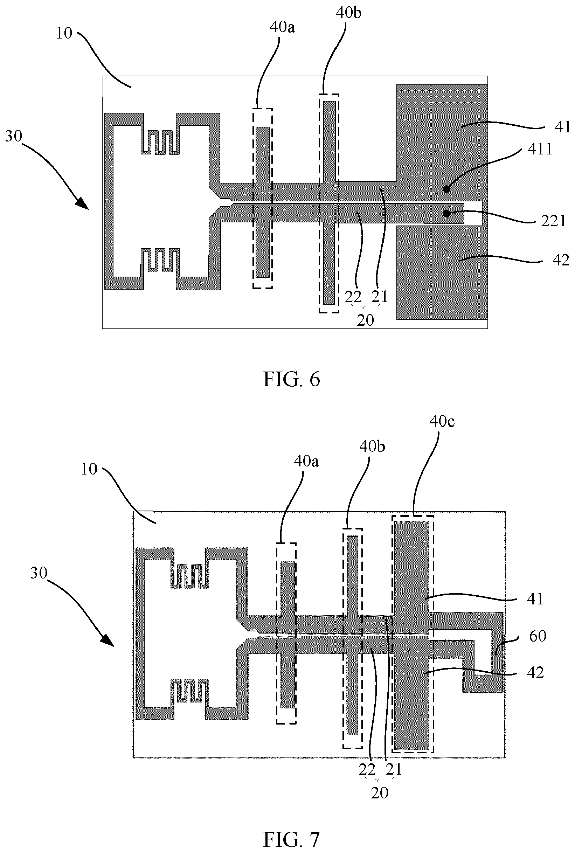

For example, as shown in FIG. 6, in an embodiment provided in this application, a slot is formed between a first vibration arm 41 and a second vibration arm 42, and an end (right end) of a second microstrip 22 extends into the slot. During connecting, an outer conductor 52 of a coaxial cable 50 may be connected to a feed end 411 of the first vibration arm 41, and an inner conductor 51 of the coaxial cable 50 may be connected to a feed end 221 on the second microstrip 22. Therefore, feeding is performed between an antenna and the coaxial cable 50 by implementing a coplanar waveguide, to balance feeding between the antenna and the coaxial cable 50.

The following uses an antenna shown in FIG. 7 as an example to describe advantageous effects of the antenna using experimental data.

In FIG. 7, the antenna includes a symmetrical dipole 40a, a symmetrical dipole 40b, a symmetrical dipole 40c, and a folded dipole 30. A distance between the symmetrical dipole 40c and the folded dipole 30 is approximately equal to half of an operating wavelength of the antenna. The symmetrical dipole 40a, the symmetrical dipole 40b, and the symmetrical dipole 40c are sequentially arranged from left to right. The three symmetrical dipoles are disposed to satisfy dimension constraints in the foregoing formulas (1) to (3).

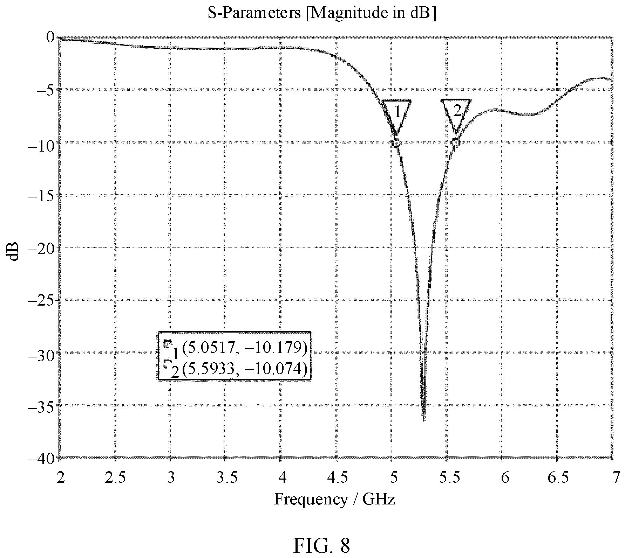

FIG. 8 shows a signal simulation diagram of an antenna. It can be seen from the figure that an operating frequency band of an antenna is approximately between 5 GHz to 5.6 GHz. Specifically, coordinates of mark 1 in the figure are approximately (5.0517, -10.179) and mark 2 are approximately (5.5933, -10.074). In the industry, a frequency less than -10 dB is usually considered as an effective power frequency of the antenna. Therefore, in the antenna provided in this application, an effective operating frequency band of the antenna is approximately between 5 GHz to 5.6 GHz.

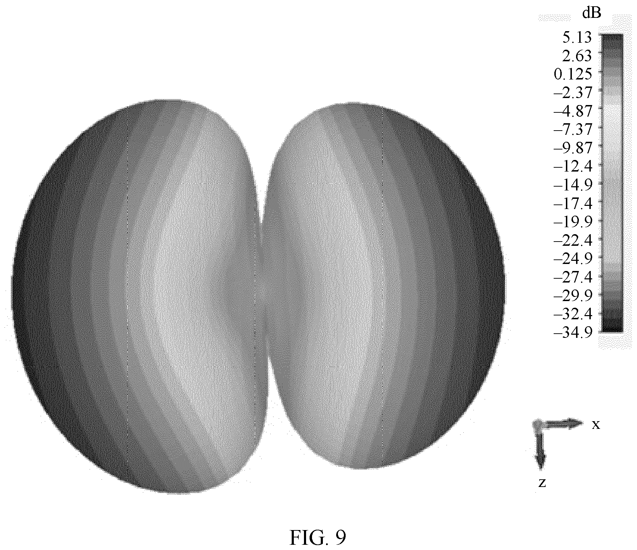

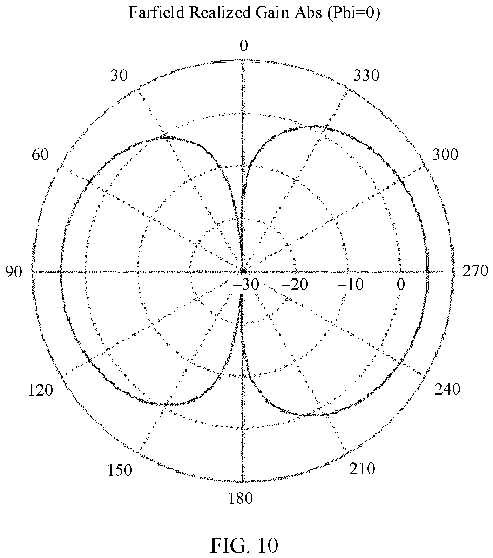

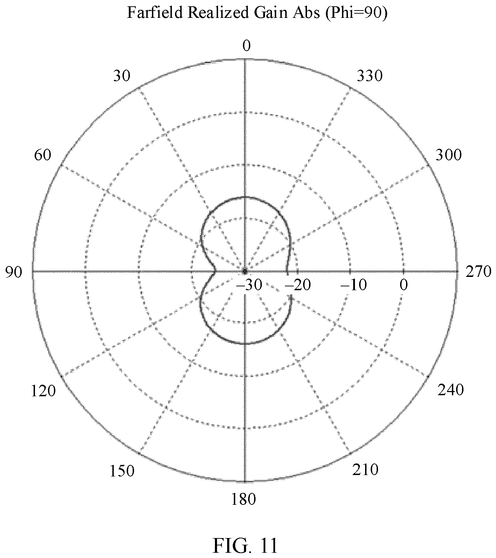

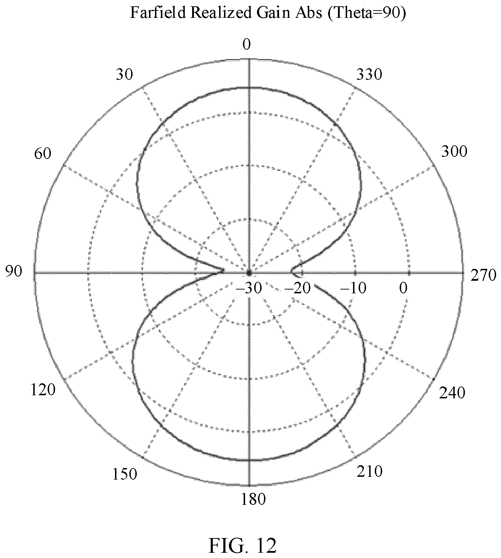

FIG. 9 shows a data simulation diagram of antenna radiation intensity in an X-Z direction. FIG. 10 shows an antenna radiation pattern on X-O-Z. FIG. 11 shows an antenna radiation pattern (also referred to as a directional pattern) on X-O-Y FIG. 12 shows an antenna radiation pattern on Y-O-Z. That is, in a three-dimensional spatial range, a radiation signal of an antenna presents a dual-beam characteristic.

In summary, according to the antenna provided in the embodiment of this application, a multi-directional radiation range can be achieved in the three-dimensional spatial range, and a multi-beam characteristic can be achieved, thereby improving use effects of the antenna.

In addition, an embodiment of this application further provides a communication device. The communication device includes the foregoing antenna. The communication device may be an optical network unit (Optical network unit, ONU), an access point (Access Point, AP), or a station (Station, STA), a wireless router, a mobile phone, a tablet computer, or any other electronic devices that use the foregoing antenna. Alternatively, the communication device may be a module that includes the foregoing antenna, or the like. The communication device may further include a signal processing circuit. The signal processing circuit is electrically connected to the antenna to input or output a radio frequency signal. The signal processing circuit may be electrically connected to the antenna through a transmission medium. The transmission medium may be, for example, a coaxial cable or any other medium. The electronic device has better antenna performance, and is capable of achieving a relatively wide frequency band and omnidirectional coverage.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An antenna, comprising:

   a dielectric substrate;
   a combined line, disposed on the dielectric substrate, wherein the combined line has a first end and a second end;
   a folded dipole, disposed on the dielectric substrate, wherein the folded dipole is located at the first end of the combined line and is connected to the combined line; and
   N symmetrical dipoles, disposed on the dielectric substrate, wherein the N symmetrical dipoles are connected to the combined line, and N is an integer greater than or equal to 1, and when N is greater than 1, the N symmetrical dipoles are sequentially arranged from the first end to the second end of the combined line.

2. The antenna according to claim 1, wherein a distance between the folded dipole and the symmetrical dipole at a tail part is L;

   the symmetrical dipole at the tail part is a symmetrical dipole located at a second end of the combined line; and
   L ranges from a quarter of an operating wavelength of the antenna to an entire operating wavelength.

3. The antenna according to claim 2, wherein L is equal to half of the operating wavelength of the antenna.

4. The antenna according to any one of claims 1 to 3, wherein the combined line comprises a first microstrip and a second microstrip; and
   the first microstrip and the second microstrip are provided in parallel, and a gap exists between the first microstrip and the second microstrip.

5. The antenna according to claim 4, wherein the symmetrical dipole comprises a first vibration arm and a second vibration arm, and the first vibration arm and the second vibration arm are symmetrically configured relative to the combined line; and
   the first vibration arm is located on a side of the first microstrip, and an end that is of the first vibration arm and that is close to the first microstrip is connected to the first microstrip; and the second vibration arm is located on a side of the second microstrip, and an end that is of the second vibration arm and that is close to the second microstrip is connected to the second microstrip.

6. The antenna according to claim 5, wherein in the symmetrical dipole at the tail part, the first vibration arm has a first feed end, and the first feed end is located at an end that is of the first vibration arm and that faces the second vibration arm;

   the second vibration arm has a second feed end, and the second feed end is located at an end that is of the second vibration arm and that faces the first vibration arm; and
   the symmetrical dipole at the tail part is a symmetrical dipole located at the second end of the combined line.

7. The antenna according to claim 6, wherein the antenna further comprises a balun structure; and
   the balun structure is disposed on a side that is of the symmetrical dipole at the tail part and that is away from the folded dipole, and is connected to the symmetrical dipole at the tail part.

8. The antenna according to claim 7, wherein the balun structure is a bent U-shaped structure; and
   one end of the balun structure is connected to the first vibration arm, and the other end is connected to the second vibration arm.

9. The antenna according to claim 4, wherein the symmetrical dipole at the tail part comprises a first vibration arm and a second vibration arm, and the first vibration arm and the second vibration arm are symmetrically configured relative to the combined line;

an end close to the first vibration arm and an end close to the second vibration arm are connected to each other, and a slot exists between the first vibration arm and the second vibration arm;

an end that is of the first vibration arm and that is close to the first microstrip is connected to the first microstrip, and an end of the second microstrip is located in the slot; and

the symmetrical dipole at the tail part is a symmetrical dipole located at a second end of the combined line, the first vibration arm or the second vibration arm has a first feed end, and the second microstrip has a second feed end.

10. The antenna according to any one of claims 4 to 9, wherein the folded dipole comprises a first connecting arm and a second connecting arm, the first connecting arm is connected to an end of the first microstrip, and the second connecting arm is connected to an end of the second microstrip.

11. The antenna according to claim 10, wherein the first connecting arm has a first extension section extending in a direction away from the second connecting arm; and

the second connecting arm has a second extension section extending in a direction away from the first connecting arm.

12. The antenna according to any one of claims 1 to 11, wherein the N symmetrical dipoles satisfy:

$$\frac{L_n}{L_{n+1}} = \tau < 1$$

wherein n is a sequence number of the symmetrical dipole, and increases sequentially from the first end to the second end of the combined line; $L_n$ is a length of an $n^{th}$ symmetrical dipole; $L_{n+1}$ is a length of an $(n+1)^{th}$ symmetrical dipole; and $\tau$ is a combination factor of the antenna.

13. The antenna according to any one of claims 1 to 12, wherein the N symmetrical dipoles satisfy:

$$\frac{R_n}{R_{n+1}} = \tau < 1$$

wherein n is the sequence number of the symmetrical dipole, and increases sequentially from the first end to the second end of the combined line; $R_n$ is a

distance from the $n^{th}$ symmetrical dipole to a virtual vertex of the antenna; $R_{n+1}$ is a distance from the $(n+1)^{th}$ symmetrical dipole to the virtual vertex of the antenna; and $\tau$ is the combination factor of the antenna.

14. The antenna according to any one of claims 1 to 13, wherein the N symmetrical dipoles satisfy:

$$\frac{d_n}{d_{n+1}} = \tau < 1$$

wherein n is the sequence number of the symmetrical dipole, and increases sequentially from the first end to the second end of the combined line; $d_n$ is a distance between the $n^{th}$ symmetrical dipole and the $(n+1)^{th}$ symmetrical dipole; $d_{n+1}$ is a distance between the $(n+1)^{th}$ symmetrical dipole and the $(n+2)^{th}$ symmetrical dipole; and $\tau$ is the combination factor of the antenna.

15. A communication device, comprising a signal processing circuit and the antenna according to any one of claims 1 to 14, wherein the signal processing circuit is electrically connected to the antenna.

FIG. 1

FIG. 2

FIG. 3

FIG. 4

FIG. 5

FIG. 6

FIG. 7

S-Parameters [Magnitude in dB]

$c_1$ (5.0517, −10.179)
$c_2$ (5.5933, −10.074)

Frequency / GHz

FIG. 8

FIG. 9

Farfield Realized Gain Abs (Phi=0)

FIG. 10

Farfield Realized Gain Abs (Phi=90)

FIG. 11

Farfield Realized Gain Abs (Theta=90)

FIG. 12

## INTERNATIONAL SEARCH REPORT

| International application No. |
| --- |
| **PCT/CN2021/124761** |

**A.  CLASSIFICATION OF SUBJECT MATTER**

H01Q 1/38(2006.01)i;  H01Q 1/36(2006.01)i;  H01Q 13/08(2006.01)i;  H01Q 21/00(2006.01)i

According to International Patent Classification (IPC) or to both national classification and IPC

**B.  FIELDS SEARCHED**

Minimum documentation searched (classification system followed by classification symbols)

H01Q H01P

Documentation searched other than minimum documentation to the extent that such documents are included in the fields searched

Electronic data base consulted during the international search (name of data base and, where practicable, search terms used)

CNTXT; CNABS; WPABS; ENTXT; DWPI; VEN; CJFD; CNKI; VEN: 折合, 天线, 对称, 振子, 集合线, 平行, 带线; folded dipole, balanced dipole, element, aggregate line, parallel, microstrip line

**C.  DOCUMENTS CONSIDERED TO BE RELEVANT**

| Category* | Citation of document, with indication, where appropriate, of the relevant passages | Relevant to claim No. |
| --- | --- | --- |
| X | CN 102394352 A (SOUTHEAST UNIVERSITY) 28 March 2012 (2012-03-28) description, paragraphs [0016]-[0018], and figures 1-7 | 1-15 |
| Y | CN 102394352 A (SOUTHEAST UNIVERSITY) 28 March 2012 (2012-03-28) description, paragraphs [0016]-[0018], and figures 1-7 | 1-15 |
| Y | CN 101710652 A (TONGYU COMMUNICATION INC.) 19 May 2010 (2010-05-19) description paragraph [0015], figures 1, 2 | 1-15 |
| Y | CN 201323236 Y (TONGYU COMMUNICATION INC.) 07 October 2009 (2009-10-07) description paragraph [0015], figures 1, 2 | 1-15 |
| X | CN 202121058 U (SOUTHEAST UNIVERSITY) 18 January 2012 (2012-01-18) description, paragraphs [0016]-[0018], figure 1 | 1-15 |
| A | CN 201503913 U (HONGBA DIGITAL TECHNOLOGY (BEIJING) CO., LTD.) 09 June 2010 (2010-06-09) entire document | 1-15 |
| A | CN 210957000 U (TP-LINK TECHNOLOGIES CO., LTD.) 07 July 2020 (2020-07-07) entire document | 1-15 |

☑ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **31 December 2021** | **10 January 2022** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2021/124761** |

**C.    DOCUMENTS CONSIDERED TO BE RELEVANT**

| Category* | Citation of document, with indication, where appropriate, of the relevant passages | Relevant to claim No. |
|---|---|---|
| A | US 2008030418 A1 (BRACHAT PATRICE et al.) 07 February 2008 (2008-02-07) entire document | 1-15 |
| A | 周小林 等 (ZHOU, Xiaolin et al.). "宽带宽波束端射印刷振子天线 (End-fire Printed Dipole Antenna with Broadband and Wave Beam Width)" 制导与引信 (Guidance & Fuze), No. 04, 15 December 2012 (2012-12-15), entire document | 1-15 |
| A | 刘其中 等 (LIU, Qizhong et al.). "带折合振子引向天线的优化设计 (An Optimum Design for Yagi-Uda Antenna with Folded Dipole)" 通信学报 (Journal on Communications), No. 05, 25 May 1993 (1993-05-25), entire document | 1-15 |

Form PCT/ISA/210 (second sheet) (January 2015)

**INTERNATIONAL SEARCH REPORT**
Information on patent family members

International application No.

**PCT/CN2021/124761**

| Patent document cited in search report | | | Publication date (day/month/year) | Patent family member(s) | | | Publication date (day/month/year) |
|---|---|---|---|---|---|---|---|
| CN | 102394352 | A | 28 March 2012 | CN | 102394352 | B | 08 January 2014 |
| CN | 101710652 | A | 19 May 2010 | CN | 101710652 | B | 23 January 2013 |
| CN | 201323236 | Y | 07 October 2009 | | None | | |
| CN | 202121058 | U | 18 January 2012 | | None | | |
| CN | 201503913 | U | 09 June 2010 | | None | | |
| CN | 210957000 | U | 07 July 2020 | | None | | |
| US | 2008030418 | A1 | 07 February 2008 | FR | 2882468 | A1 | 25 August 2006 |
| | | | | DE | 602006001942 | D1 | 04 September 2008 |
| | | | | US | 7432873 | B2 | 07 October 2008 |
| | | | | WO | 2006087488 | A1 | 24 August 2006 |
| | | | | AT | 402500 | T | 15 August 2008 |
| | | | | EP | 1849213 | A1 | 31 October 2007 |
| | | | | EP | 1849213 | B1 | 23 July 2008 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011529058